# DEMANDE DE BREVET EUROPEEN

(11) **EP 4 818 725 A1**
(43) Date de publication de la demande: **07.10.2026**
(21) Numéro de dépôt: 26170461.3
(22) Date de dépôt: 02.04.2026
(51) Int. Cl.: G01R 31/392, G01R 31/396, G01R 31/3842

(54) **PROCÉDÉ DE DÉTECTION D'UN DÉFAUT DANS UNE BATTERIE D ACCUMULATEURS**

(30) Priorité: 04.04.2025 FR 2503530
(71) Demandeur: AMPERE s.a.s., 92100 Boulougne-Billancourt (FR)
(72) Inventeur: CREGUT, Samuel, 78280 GUYANCOURT (FR); DUGUE, Vincent, 78280 GUYANCOURT (FR); KALAWOUN, Jana, 78280 GUYANCOURT (FR)
(74) Mandataire: Renault Group

(57) **Abrégé**

Ce procédé de détection d'un défaut dans une batterie d'accumulateurs comprenant un ensemble de cellules, caractérisé en ce qu'il comprend les étapes suivantes :
- Mesure (étape E1) régulière de la tension de chaque cellule de la batterie sur une plage d'état de charge prédéfinie de ladite batterie ;
- Détermination du premier instant (étape E2) au cours duquel la tension mesurée d'une cellule varie selon un motif prédéfini ;
- Détermination du dernier instant (étape E3) au cours duquel la tension mesurée d'une cellule varie selon le motif prédéfini ;
- Calcul (étape E4) de la charge, en Ah, ayant traversé la batterie entre le premier instant et le dernier instant déterminés ; et
- Comparaison (étape E5) de la charge à un seuil de défaillance prédéfini.

## Description

### Domaine technique

La présente invention concerne la détection de défaut dans un dispositif de stockage d'énergie.

En particulier, la présente invention concerne la détection de défauts dans des batteries d'accumulateurs lithium ion, notamment de type LFP (lithium, fer, phosphate).

Ces batteries sont par exemples utilisés pour l'alimentation d'un système de motorisation d'un véhicule automobile électrique.

### Techniques antérieures

Une batterie d'accumulateurs est généralement formée d'un ensemble de cellules, dites cellules élémentaires, connectées en série.

Ces cellules élémentaires sont hétérogènes et ne se comportent pas toutes de la même manière, induisant un écart entre leurs différents états de charge.

Cette hétérogénéité peut être liée à la fabrication d'une cellule ou à un autre facteur, tel que l'emplacement de ladite cellule au sein de la batterie.

L'écart entre l'état de charge des cellules induit une perte de l'énergie globale disponible dans l'ensemble de la batterie, aussi appelée pack. En effet, la cellule la plus chargée en énergie va être limitante en charge, et celle la moins chargée va l'être en décharge.

De ce fait, la batterie subit une perte d'énergie correspondante à l'écart entre l'état de charge de la cellule la plus chargée et celle la moins chargée.

Par ailleurs, une batterie dispose d'un calculateur, appelé BMS (pour « Battery Management System », système de contrôle de la batterie en termes anglo-saxons), permettant entre autres d'équilibrer les états de charge des différentes cellules.

Cependant, lorsqu'une cellule est défaillante, par exemple présentant un court-circuit interne, le BMS n'est plus capable de compenser cette perte importante d'énergie, la différence d'état de charge étant trop importante ou tout simplement impossible à combler du fait de la défaillance de ladite cellule.

On rappelle ici que l'état de charge représente un pourcentage, compris entre 0% et 100% de la capacité de la batterie, ou d'une cellule. Ladite capacité est exprimée en Ah, celle-ci étant déterminée de manière connue en soi par le BMS, notamment par une méthode de type comptage coulométrique. L'état de charge est également appelé SOC (« state of charge » en termes anglo-saxons).

La solution actuelle pour diagnostiquer ce type de défaillance d'une cellule repose sur la mesure de la tension aux bornes de chaque cellule et sur la détermination de l'écart de tension entre la cellule ayant la tension à ses bornes la plus élevée et la cellule ayant à ses bornes la tension la plus faible.

Cette solution est mise en œuvre lorsque la batterie est dans un état non-polarisée, i.e., lorsqu'aucun courant n'a traversé la batterie depuis plusieurs heures. Dans ce cas, la tension mesurée aux bornes de chaque cellule est appelée OCV (pour « Open Circuit Voltage », tension de circuit ouvert en termes anglo-saxons).

Cette solution est particulièrement pertinente pour des cellules de batterie de type NMC (nickel, manganèse, cobalt).

En effet, les cellules NMC peuvent avoir un écart important de tension à leurs bornes pour une variation d'état de charge de 10% à 99%, par exemple de l'ordre de 750 mV.

A l'inverse, pour des cellules LFP, la tension aux bornes d'une cellule varie beaucoup moins sur une large plage d'état de charge. On constate par exemple une variation de 200 mV seulement pour une variation d'état de charge de 10% à 99%.

Ainsi, pour certaines cellules de batterie, notamment LFP, un important écart d'état de charge entre deux cellules n'est pas repérable aisément par mesure d'une différence de tension aux bornes desdites cellules.

Le BMS ne peut alors pas détecter la défaillance d'une cellule afin d'alerter le conducteur pour un remplacement de ce composant défaillant de sa batterie.

### Exposé de l'invention

La présente invention a donc pour but de pallier les inconvénients précités et de fournir un procédé de détection de défaut dans une batterie qui soit rapide et adapté aux batteries lithium, fer, phosphate.

La présente invention a pour objet un procédé de détection d'un défaut dans une batterie d'accumulateurs comprenant un ensemble de cellules, le procédé comprenant les étapes suivantes :
- Mesure régulière de la tension de chaque cellule de la batterie sur une plage d'état de charge prédéfinie de ladite batterie ;
- Détermination du premier instant au cours duquel la tension mesurée d'une cellule varie selon un motif prédéfini ;
- Détermination du dernier instant au cours duquel la tension mesurée d'une cellule varie selon le motif prédéfini ;
- Calcul de la charge, en Ah, ayant traversé la batterie entre le premier instant et le dernier instant déterminés ; et
- Comparaison de la charge à un seuil de défaillance prédéfini.

Ainsi, la charge ayant traversé la batterie entre le premier instant et le dernier instant correspond à l'écart en Ah existant entre la cellule la plus chargée et la moins chargée. Cet écart peut ensuite être comparé à un seuil de défaillance. Si l'écart est supérieur audit seuil, un défaut est détecté dans la batterie et une alerte peut être envoyée à l'utilisateur.

Avantageusement, la plage d'état de charge prédéfinie correspond à une plage comprise entre 30% et 95% d'état de charge, de préférence entre 45% et 70% d'état de charge, encore plus préférentiellement entre 50% et 60% d'état de charge.

Avantageusement, l'étape de mesure est mise en œuvre au cours d'une charge ou d'une décharge de la batterie.

Dans un mode particulier de mise en œuvre, la charge ou la décharge de la batterie est effectuée avec un courant de charge ou de décharge sensiblement constant et de sorte que les tensions mesurées de chaque cellule sont similaires à des tensions en circuit ouvert de chaque cellule, à 5% près.

Avantageusement, le motif prédéfini est un changement de la valeur de la dérivée de la tension mesurée, le changement étant supérieur à une valeur prédéfinie.

Dans un mode particulier de mise en œuvre, la batterie a une charge maximale admissible, le seuil de défaillance prédéfini étant compris entre 5% et 30% de la charge maximale admissible par la batterie, de préférence entre 10% et 20%.

Avantageusement, l'étape de mesure est réalisée au moins tous les 2% d'état de charge de la batterie, de préférence au moins tous les 0,5% d'état de charge de la batterie.

Avantageusement, la batterie est une batterie lithium, fer, phosphate.

Dans un mode particulier de mise en œuvre, le procédé est mis en œuvre par un système de contrôle de la batterie.

La présente invention a également pour objet une batterie d'accumulateurs comprenant un système de contrôle de la batterie configuré pour mettre en œuvre le procédé tel que défini précédemment.

### Brève description des dessins

D'autres buts, caractéristiques et avantages de l'invention apparaîtront à la lecture de la description suivante, donnée uniquement à titre d'exemple non limitatif, et faite en référence aux dessins annexés sur lesquels :
[Fig 1]
   est une vue schématique d'une batterie selon l'invention ;
[Fig 2]
   est une représentation schématique des différentes étapes du procédé selon l'invention ; et
[Fig 3]
   est une représentation d'une courbe de tension d'une cellule de batterie en fonction de son état de charge.

### Exposé détaillé d'au moins un mode de réalisation

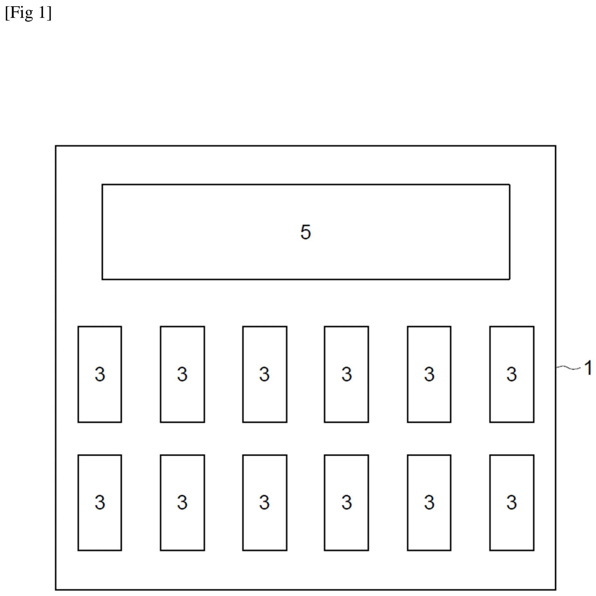

On a représenté schématiquement sur la figure 1 une batterie 1 d'accumulateurs comprenant un ensemble de cellules 3 reliées en série.

La batterie 1 est de préférence une batterie 1 lithium, fer, phosphate.

Un exemple de batterie 1 est par exemple une batterie 1 comprenant entre 50 et 150 cellules 3, chacune ayant une capacité de charge de 150 à 200 Ah (Ampère heure). La charge maximale admissible de la batterie 1, notée Qₘₐₓ, est la somme des capacités de charge de chaque cellule 3.

La batterie 1 comprend également un système 5 de contrôle de la batterie 1, mentionné précédemment et autrement appelé BMS.

Ce système 5 de contrôle de la batterie 1 est adapté pour mesurer la tension aux bornes de chaque cellule 3, autrement appelée tension de chaque cellule 3, ainsi que pour mesurer le courant traversant la batterie 1.

En outre, le système 5 de contrôle de la batterie 1 est configuré pour mettre en œuvre le procédé selon l'invention, décris ci-après.

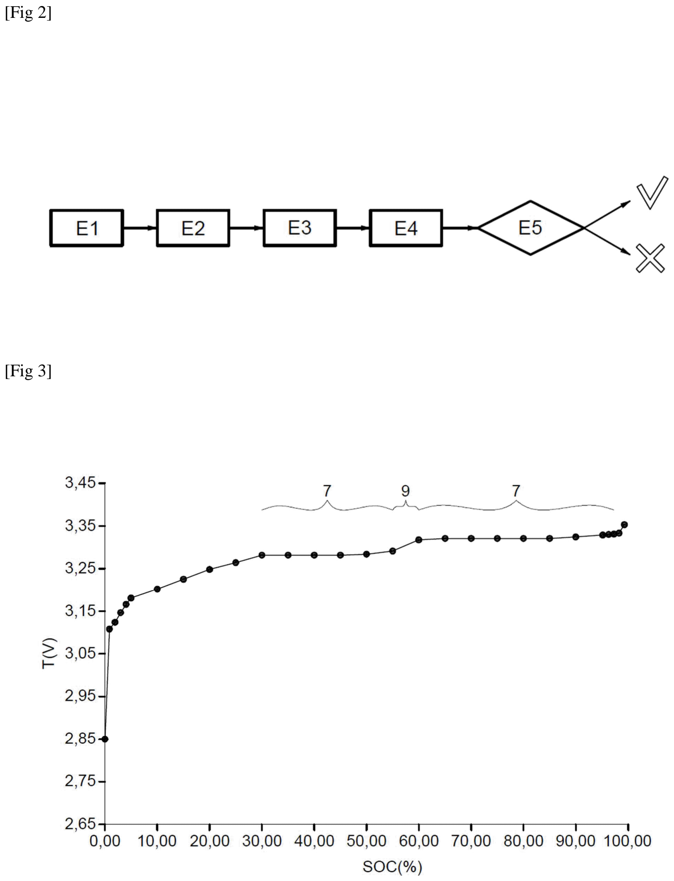

On a représenté sur la figure 2 les différentes étapes du procédé de détection d'un défaut dans la batterie 1.

En premier lieu, on effectue une étape E1 de mesure régulière de la tension de chaque cellule 3 de la batterie 1 sur une plage d'état de charge prédéfinie de ladite batterie 1.

Cette étape E1 de mesure est menée de préférence pendant la charge ou la décharge de la batterie 1, de manière à pouvoir gagner du temps et automatiser et simplifier la détection de défaut pendant l'usage de la batterie 1 et pas uniquement en laboratoire.

On a représenté sur la figure 3 un exemple de courbe de tension T d'une cellule 3 de batterie 1 en fonction de son état de charge SOC, exprimé en pourcentage.

La présente courbe est par exemple obtenue en circuit ouvert mais une courbe de tension équivalente peut être obtenue pendant une charge ou une décharge lente de la batterie 1, à savoir à l'aide d'un courant de charge ou de décharge sensiblement constant et sur une durée supérieure à une durée prédéfinie, telle que cinq heures, de sorte que la courbe de tension pendant la charge ou la décharge soit similaire à la courbe de tension en circuit ouvert. On entend par exemple par sensiblement constant un courant dont la valeur reste constante à 10% près.

Par exemple, on considère qu'une courbe de tension pendant la charge ou la décharge est similaire à la courbe de tension en circuit ouvert lorsque les tensions mesurées de chaque cellule 3 sont similaires aux tensions en circuit ouvert de chaque cellule 3, à 5% près.

Cette étape E1 de mesure, lorsque menée en circuit ouvert ou pendant une charge ou une décharge à courant sensiblement constant, permet d'obtenir une courbe présentant deux zones dites planes 7 séparées d'une zone de pente 9, et ce notamment pour les batteries 1 lithium, fer, phosphate.

Une zone plane 7 a par exemple une pente faible inférieure à 3 mV sur 20% d'état de charge.

La zone de pente 9 a par exemple une pente de plus de 5 mV sur 10% d'état de charge.

La plage d'état de charge prédéfinie sur laquelle est menée l'étape E1 de mesure de tension est une plage comprise entre 30% et 95% d'état de charge, de préférence entre 45% et 70% d'état de charge, encore plus préférentiellement entre 50% et 60% d'état de charge. Ces plages correspondent en particulier aux plages usuelles dans lesquelles les zones planes 7 et la zone de pente 9 les séparant sont visibles sur la courbe de tension d'une cellule 3 de batterie 1 en fonction de son état de charge, notamment pour les batteries 1 lithium, fer, phosphate.

Dans un mode particulier de mise en œuvre, l'étape E1 de mesure est réalisée régulièrement au moins tous les 2% d'état de charge de la batterie 1, de préférence au moins tous les 0,5% d'état de charge de la batterie 1.

Cette régularité permet d'obtenir une courbe de tension en fonction de l'état de charge la plus précise possible.

En variante, l'étape E1 de mesure est réalisée au moins toutes les 500 ms, de préférence toutes les 100 ms.

Puis, on effectue une étape E2 de détermination du premier instant t1 au cours duquel la tension mesurée d'une cellule 3 varie selon un motif prédéfini.

En particulier, le motif prédéfini est une variation de la tension de la cellule 3 correspondant à la zone de pente 9 précédemment référencée, par exemple une variation correspondant au début ou à la fin de la zone de pente 9, à savoir le changement soudain de pente entre l'une des deux zones planes 7 et la zone de pente 9.

Le premier instant t1 correspond en d'autres termes à l'instant pour lequel la tension de la première cellule 3, parmi toutes les cellules 3 de la batterie 1, traverse le motif prédéfini.

Puis, on effectue une étape E3 de détermination du dernier instant t2 au cours duquel la tension mesurée d'une cellule 3 varie selon le même motif prédéfini.

Le dernier instant t2 correspond en d'autres termes à l'instant pour lequel la tension de la dernière cellule 3, parmi toutes les cellules 3 de la batterie 1, traverse le motif prédéfini. Il s'agit généralement de la cellule 3 la moins saine de la batterie 1, cette dernière pouvant présenter un défaut.

Le motif prédéfini étant par exemple un changement de pente particulier, il peut également être qualifié comme un changement de la valeur de la dérivée de la tension mesurée à l'étape E1 de mesure, le changement étant supérieur à une valeur prédéfinie afin d'éliminer les variations minimes.

On effectue ensuite une étape E4 de calcul de la charge *δQ* ayant traversé la batterie 1 entre le premier instant t1 et le dernier instant t2 déterminés.

Cette étape de calcul est par exemple effectuée selon la formule ci-dessous : $δQ = {\int }_{t 1}^{t 2} I \left(t\right) dt$ avec I l'intensité du courant traversant la batterie 1.

Enfin, on effectue une étape E5 de comparaison de la charge *δQ* à un seuil de défaillance prédéfini afin de déterminer si la batterie 1 présente un défaut ou non. Si le seuil de défaillance prédéfini est dépassé, la batterie 1 peut être considérée comme présentant un défaut.

Le seuil de défaillance prédéfini est par exemple compris entre 5% et 30% de la charge maximale admissible Qₘₐₓ par la batterie 1, de préférence entre 10% et 20% de ladite charge maximale admissible Qₘₐₓ.

## Revendications

1. Procédé de détection d'un défaut dans une batterie (1) d'accumulateurs comprenant un ensemble de cellules (3), **caractérisé en ce qu'**il comprend les étapes suivantes :
- Mesure (étape E1) régulière de la tension de chaque cellule (3) de la batterie (1) sur une plage d'état de charge prédéfinie de ladite batterie (1) ;
- Détermination du premier instant (étape E2) au cours duquel la tension mesurée d'une cellule (3) varie selon un motif prédéfini ;
- Détermination du dernier instant (étape E3) au cours duquel la tension mesurée d'une cellule (3) varie selon le motif prédéfini ;
- Calcul (étape E4) de la charge, en Ah, ayant traversé la batterie (1) entre le premier instant et le dernier instant déterminés ; et
- Comparaison (étape E5) de la charge à un seuil de défaillance prédéfini.

2. Procédé selon la revendication 1, dans lequel la plage d'état de charge prédéfinie correspond à une plage comprise entre 30% et 95% d'état de charge, de préférence entre 45% et 70% d'état de charge, encore plus préférentiellement entre 50% et 60% d'état de charge.

3. Procédé selon l'une des revendications 1 et 2, dans lequel l'étape (E1) de mesure est mise en œuvre au cours d'une charge ou d'une décharge de la batterie (1).

4. Procédé selon la revendication 3, dans lequel la charge ou la décharge de la batterie (1) est effectuée avec un courant de charge ou de décharge sensiblement constant et de sorte que les tensions mesurées de chaque cellule (3) sont similaires à des tensions en circuit ouvert de chaque cellule (3), à 5% près.

5. Procédé selon l'une quelconque des revendications 1 à 4, dans lequel le motif prédéfini est un changement de la valeur de la dérivée de la tension mesurée, le changement étant supérieur à une valeur prédéfinie.

6. Procédé selon l'une quelconque des revendications 1 à 5, dans lequel la batterie (1) a une charge maximale admissible, le seuil de défaillance prédéfini étant compris entre 5% et 30% de la charge maximale admissible par la batterie (1), de préférence entre 10% et 20%.

7. Procédé selon l'une quelconque des revendications 1 à 6, dans lequel l'étape (E1) de mesure est réalisée au moins tous les 2% d'état de charge de la batterie (1), de préférence au moins tous les 0,5% d'état de charge de la batterie (1).

8. Procédé selon l'une quelconque des revendications 1 à 7, dans lequel la batterie (1) est une batterie (1) lithium, fer, phosphate.

9. Procédé selon l'une quelconque des revendications 1 à 8 mis en œuvre par un système de contrôle (5) de la batterie (1).

10. Batterie (1) d'accumulateurs comprenant un système de contrôle (5) de la batterie (1) configuré pour mettre en œuvre le procédé selon l'une quelconque des revendications 1 à 9.
